(19) Europäisches Patentamt
European Patent Office
Office européen des brevets

(11) **EP 4 749 679 A1**

(12) **EUROPEAN PATENT APPLICATION**

(43) Date of publication:
**27.05.2026 Bulletin 2026/22**

(21) Application number: **24214067.1**

(22) Date of filing: **20.11.2024**

(51) International Patent Classification (IPC):
***H01J 37/147*** (2006.01)

(52) Cooperative Patent Classification (CPC):
**H01J 37/147;** H01J 2237/151

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventors:
• **KRECINIC, Faruk**
**5500 AH Veldhoven (NL)**

• **WIELAND, Marco, Jan-Jaco**
**5500 AH Veldhoven (NL)**
• **MANGNUS, Albertus, Victor, Gerardus**
**5500 AH Veldhoven (NL)**
• **LÖW, Peter**
**5500 AH Veldhoven (NL)**
• **KONING, Johan, Joost**
**5500 AH Veldhoven (NL)**
• **TOONEN, Wiebe, Floris**
**5500 AH Veldhoven (NL)**

(74) Representative: **ASML Netherlands B.V.**
**Corporate Intellectual Property**
**P.O. Box 324**
**5500 AH Veldhoven (NL)**

(54) **CHARGED PARTICLE-OPTICAL ELEMENT**

(57) A charged particle-optical element configured to operate on a plurality of charged particle beams in a beam grid, the charged particle-optical element comprises: a first surface and a second surface, wherein each of the first surface and the second surface: has a plurality of apertures defined in it for allowing the beams to pass through, is angled relative to a plane perpendicular to an axis of the beam grid; and faces another surface of the charged particle-optical element at a potential difference, such that the charged particle-optical element is configured to apply a deflection to the beams by controlling the potential difference.

Fig. 3

EP 4 749 679 A1

## Description

FIELD

The present invention relates to a charged particle-optical element, a charged particle-optical device, a method of projecting a plurality of charged particle beams and a method of projecting a charged particle beam.

BACKGROUND

During manufacturing processes of, for example, semiconductor integrated circuit (IC) chips or displays, undesired defects may occur on a substrate (e.g. wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relates to defects, for example the existence and classification of such defects. Electron microscopes typically generate a probe beam (also often referred to as primary beam) which may, for example, be scanned across a part of the substrate (such as in a scanning electron microscopes (SEM)). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect) inspection. The interaction products may contain charged particles which may be referred to as signal particles (e.g. signal electrons), such as secondary electrons and backscattered electrons, and may contain other interaction products, such as X-ray radiation and even light.

To increase throughout, multi-beam systems are known that scan a plurality of beams, over the sample. Such a plurality of beams may be referred to as a multi-beam or beam grid in which the beams are arranged relative to each other. Such systems may use charged particle-optical elements to deflect the multi-beam. A deflector may be implemented using multiple sets of parallel plate deflectors. Implementing charged particle-optical elements for multi-beam systems can be challenging, particularly for multi-beam systems having many beams. In the case of the parallel plate deflectors, the individual plates may for example need to be very long and thin, which can present fabrication challenges and/or lead to fragility. Similarly, for a single beam system a deflector may be fragile.

SUMMARY

It is an object of the present disclosure to provide apparatus and methods that facilitate control of a single beam or a multi-beam of charged particles.

According to the present invention, there is provided a charged particle-optical element configured to operate on a plurality of charged particle beams in a beam grid, the charged particle-optical element comprising: a first surface and a second surface, wherein each of the first surface and the second surface: has a plurality of apertures defined in it for allowing the beams to pass through, is angled relative to a plane perpendicular to an axis of the beam grid; and faces another surface of the charged particle-optical element at a potential difference, such that the charged particle-optical element is configured to apply a deflection to the beams by controlling the potential difference.

According to the present invention, there is provided a method of projecting a plurality of charged particle beams in a beam grid towards a sample, the method comprising: operating on the beams with a charged particle-optical element comprising first surface and a second surface, wherein each of the first surface and the second surface: has a plurality of apertures defined in it for allowing the beams to pass through, is angled relative to a plane perpendicular to an axis of the beam grid; and faces another surface of the charged particle-optical element at a potential difference; and applying a deflection to beams of the beam grid by controlling the potential difference.

According to the present invention, there is provided a charged particle-optical element configured to operate on a charged particle beam, the charged particle-optical element comprising: a first surface and a second surface, wherein each of the first surface and the second surface: has apertures defined in it for allowing the beam to pass through, is angled relative to a plane perpendicular to an axis of the beam; and faces another surface of the charged particle-optical element at a potential difference, such that the charged particle-optical element is configured to apply a deflection to the beam by controlling the potential difference.

According to the present invention, there is provided a method of projecting a charged particle beam towards a sample, the method comprising: operating on the beam with a charged particle-optical element comprising a first surface and a second surface, wherein each of the first surface and the second surface: has an aperture defined in it for allowing the beam to pass through, is angled relative to a plane perpendicular to an axis of the beam; and faces another surface of the charged particle-optical element at a potential difference; and applying a deflection to beam by controlling the potential difference.

BRIEF DESCRIPTION OF THE DRAWINGS

Embodiments of the invention will now be described, by way of example only, with reference to the accompanying schematic drawings, in which:

- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a multi-beam charged particle-optical device, for example of the assessment apparatus of Figure 1;
- Figure 4 schematically depicts an alternative multi-beam charged particle-optical device, for example of the assessment apparatus of Figure 1;
- Figure 5 schematically depicts an alternative multi-beam charged particle-optical device, for example of the assessment apparatus of Figure 1;
- Figure 6 schematically depicts a charged particle-optical device array;
- Figure 7 schematically depicts a single beam charged particle-optical device, for example of the assessment apparatus of Figure 1;
- Figure 8 schematically depicts a change in the propagation direction (or deflection) of a charged particle due to its deceleration by a uniform electric field between horizontally oriented parallel plates;
- Figure 9 schematically depicts a change in the propagation direction (or deflection) of a charged particle in a case where the parallel plates of Figure 8 are inclined obliquely relative to the vertical;
- Figure 10 is a schematic diagram of a charged particle-optical element configured to deflect one or more beams;
- Figure 11 is a schematic diagram of an alternative charged particle-optical element configured to deflect one or more beams;
- Figure 12 is a schematic diagram of an alternative charged particle-optical element configured to deflect one or more beams
- Figure 13 is a schematic diagram of an alternative charged particle-optical element configured to deflect one or more beams;
- Figure 14 is a schematic diagram of an alternative charged particle-optical element configured to deflect beams; and
- Figure 15 is a schematic diagram of an alternative charged particle-optical element configured to deflect beams.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device

DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7-8%. It is desirable to determine defects quickly so as to maintain a high substrate throughput, defined as the number of substrates processed per hour.

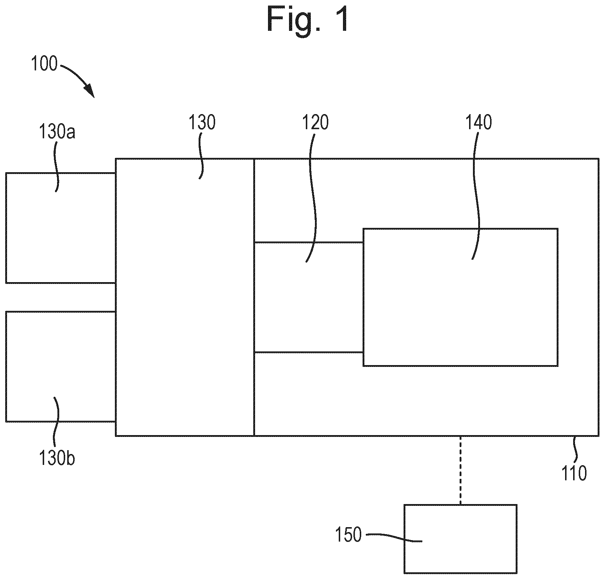

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample can be generated. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus than a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

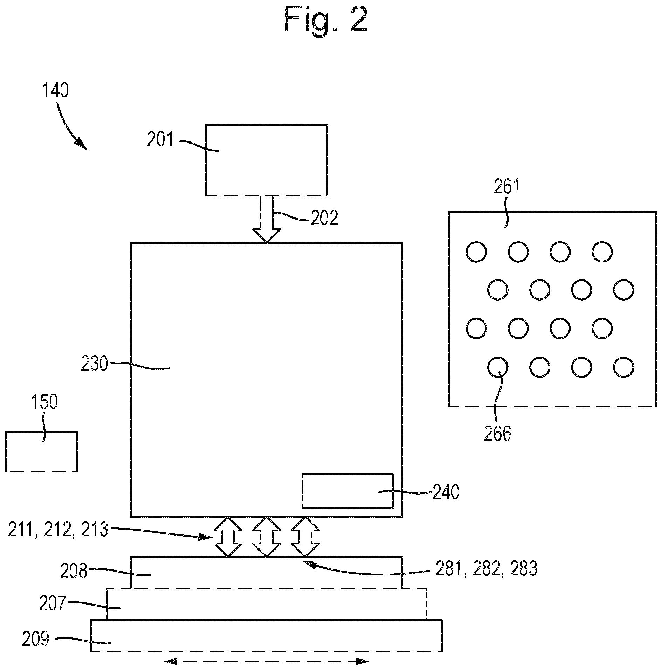

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208 which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

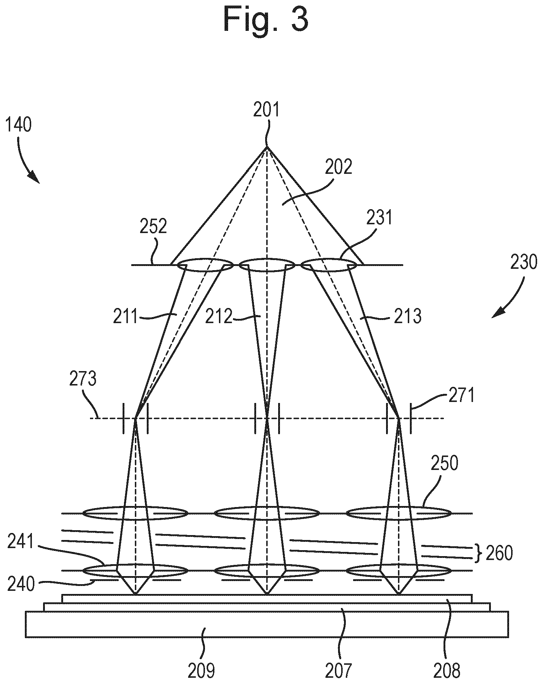

Figure 3 schematically depicts an electron-optical apparatus 140 of an assessment apparatus, e.g. the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 desirably at an intermediate focus plane 273, a control lens array 250, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Additionally or alternatively the collimator array 271 may comprise a lens array that operates on the different beams to deflect the relative paths of the beams. The collimator array 271 may be electrostatic. The collimator array 271 may consist of a single plate 261 comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lens. In a further alternative embodiment, the electron-optical device 230 comprises a macro collimator in addition to the collimator array 271.

The control lens array 250 may be upbeam of the objective lens array 241. The control lens array 250 may comprise a stack of plates 261, for example at least three plates 261. The control lens array 250 may be configured to control electron-optical parameters of the primary beams 211, 212, 213. The control lens array 250 may be upbeam of the scan deflector array 260. In an alternative embodiment, the control lens array 250 may be downbeam of the scan deflector array 260. The most downbeam plate of the control lens array 250 may be the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241.

The objective lens array 241 is configured to focus the primary beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, e.g. between the condenser lens array and the collimator array.

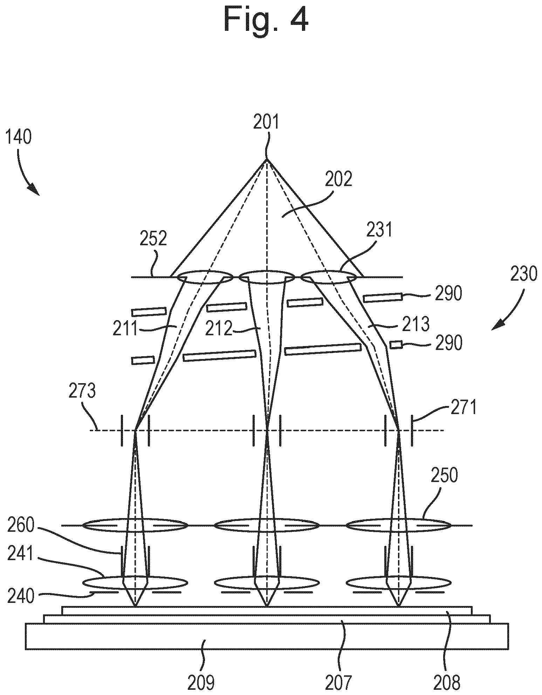

Figure 4 schematically depicts an electron-optical apparatus 140 of an assessment apparatus, e.g. the assessment apparatus 100 of Figure 1. The electron-optical apparatus 140 of Figure 4 may be the electron-optical apparatus 140 of Figure 2 in which the electron-optical elements of the electron-optical device 230 comprise a beam limiting aperture array 252, a condenser lens array 231, an alignment adjuster 290, a collimator array 271 desirably at an intermediate focus plane 273, a control lens array 250, a scan deflector array 260, an objective lens array 241 and the detector array 240.

The alignment adjuster 290 may comprise a pair of charged particle-optical elements configured to adjust alignment of the beam grid in a direction perpendicular to the axis of the beam grid. Each charged particle-optical element may be configured to deflect the beams by controlling a potential difference between two surfaces of the charged particle-optical element. In an embodiment, one pair of charged particle-optical elements is configured to adjust alignment in one direction in the x-y plane. In an embodiment a second pair of charged particle-optical elements is configured to adjust alignment in another, e.g. orthogonal, direction in the x-y plane. In an embodiment each of the beams upbeam of the alignment adjuster 290 is parallel to that beams downbeam of the alignment adjuster 290, but is shifted in the x-y plane.

In Figure 4, the alignment adjuster 290 is shown downbeam of the condenser lens array 231 and upbeam of the collimator array 271. Additionally or alternatively, an alignment adjuster 290 may be provided upbeam of the condenser lens array 231 and/or downbeam of the collimator array 271.

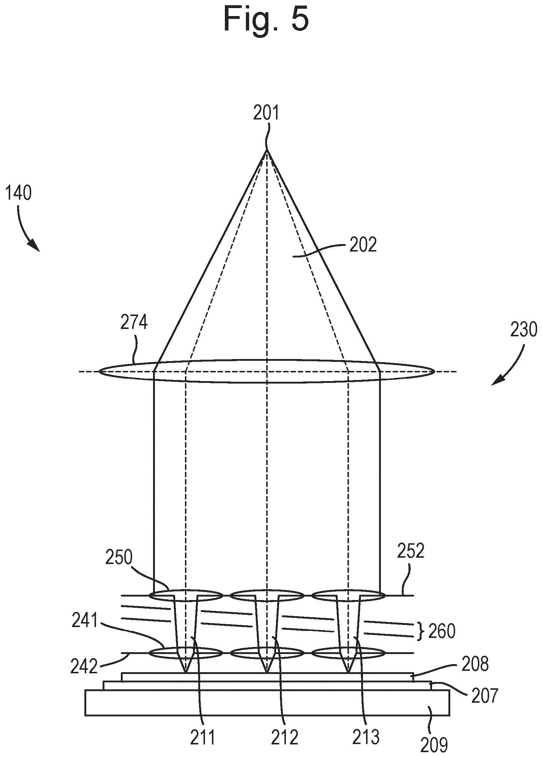

Figure 5 schematically depicts an electron-optical apparatus 140 of an assessment apparatus, e.g. the assessment apparatus 100 of Figure 1. The electron-optical apparatus 140 of Figure 5 may be the electron-optical apparatus 140 of Figure 2 in which the electron-optical device 230 comprises a macro condenser lens 274, a beam limiting aperture array 252 (which may be referred to as an upper beam limiter), a control lens array 250, a scan deflector array 260, an objective lens array 241, a beam shaper array 242 (which may be referred to as a lower beam limiter) and the detector array 240 (not shown, but similar to Figs. 3 and 4).

The source 201 generates a diverging source beam 202. The macro condenser lens 274 is located between the source 201 and the objective lens array 241. The macro condenser lens 274 is configured to at least partly collimate the source beam 202. The scan deflector array 260 is configured to operate on the primary beams 211, 212, 213 to scan the surface of the sample 208. The macro condenser lens 274 may at least in part be magnetic.

The beam limiting aperture array 252 defines a plurality of primary beams 211, 212, 213 from the source beam 202. The beam shaper array 242 and the beam limiting aperture array 252 are plates 261 in which the beam apertures 266 are smaller in dimension than other plates of the electron-optical device 230. The beam apertures 266 of the beam limiting aperture array 252 define the primary beams 211, 212, 213. The beam apertures 266 of the beam shaper array 242 shape the primary beams 211, 212, 213 to at least partially correct for types of aberration in the beams.

The objective lens array 241 is configured to focus the primary beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the primary beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly.

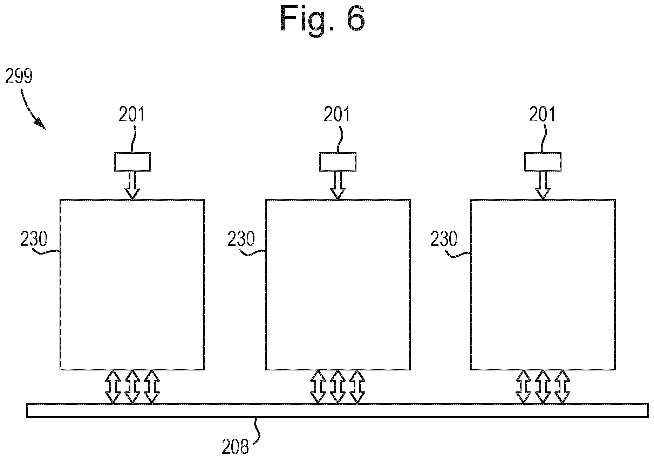

Figure 6 schematically depicts an electron-optical device array 299. In an embodiment the assessment apparatus 100 of Figure 1 comprises the electron-optical device array 299 instead of the electron-optical apparatus 140. Such an electron-optical device array 299 is also referred to as a multi-column array. The different columns (or electron-optical devices 230) may comprise in use a plurality of beams such as a beam grid. In an embodiment the electron-optical device array 299 comprises a plurality of electron-optical devices 230 of the type shown in Figure 2.

In an embodiment, one or more electron-optical elements may be shared between more than one of the electron-optical devices 230 of the electron-optical device array 299. The electron-optical elements may comprise one or more plates 261 in which a plurality of beam apertures 266 are defined for respective beam paths. In an embodiment, one or more sources 201 may be shared between more than one of the electron-optical devices 230 of the electron-optical device array 299. The sources may be comprised in a source array having different sources generating a source beam for different respective electron-optical device 230.

The electron-optical devices 230 may focus respective multi-beams simultaneously onto different regions of the same sample 208. In a different embodiment, the electron-optical devices 230 of the electron-optical device array 299 may project respective single beams towards the sample 208.

Each electron-optical device 230 of the electron-optical device array 299 may be configured in any of the ways described herein. The disclosure in WO 2022008286 A1 of how the objective lens is incorporated and adapted for use in the multi-device arrangement is hereby incorporated by reference. The disclosure in WO 2021165135 A1 of a multi-device arrangement of a multi-beam device comprising a collimator at, or proximate to, an intermediate focus is hereby incorporated by reference.

Features in electron-optical plates may be manufactured using techniques from microelectromechanical systems (MEMS) (i.e. using MEMS manufacturing techniques). MEMS are miniaturized mechanical and electromechanical elements that are made using microfabrication techniques. Merely as an example, a collimator array may be formed using MEMS manufacturing techniques so as to be spatially compact. As another example, a scan deflector array may be formed using MEMS manufacturing techniques.

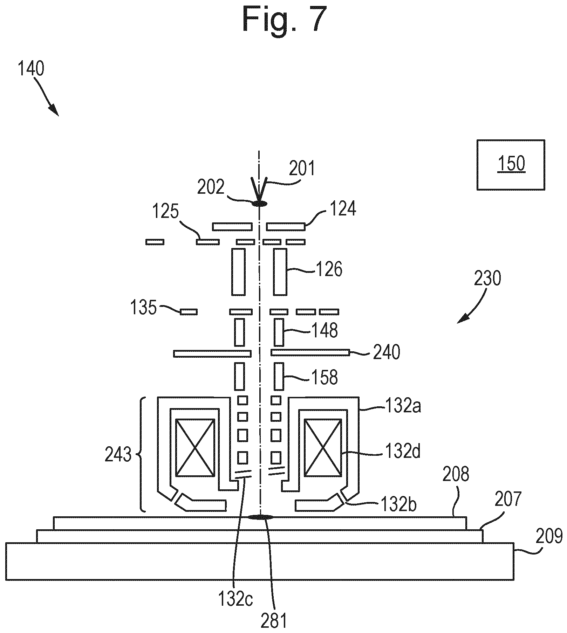

Figure 7 schematically depicts an electron-optical apparatus 140 of an assessment apparatus, e.g. the assessment apparatus 100 of Figure 1. As shown in Figure 7, in an embodiment the electron-optical apparatus 140 comprises an electron-optical device 230 that comprises a beam limit aperture 125 (the image actually shows an array of selectable beam limiting apertures), a condenser lens 126, a column aperture 135 (again indicated as an array of selectable column apertures 135), an objective lens 243 and a detector array 240.

The source 201 is configured to generate a source beam 202. A gun aperture 124 blocks peripheral electrons of the source beam 202. The source beam 202 passes through the beam limit aperture 125, the condenser lens 126 and the column aperture 135. The condenser lens 126 may be magnetic, electrostatic or a combination of magnetic and electrostatic.

In an embodiment the electron-optical device 230 comprises electromagnetic multipole, e.g. quadrupole, electron lenses. For example, the electron-optical device 230 may comprise a first multipole lens 148 and a second multipole lens 158. In an embodiment, the first multipole lens 148 and the second multipole lens 158 are used for controlling the source beam 202. For example, the first multipole lens 148 may be configured to adjust the beam current of the source beam 202. The second multipole lens 158 may be configured to adjust the size of the probe spot 281 and/or the shape of the source beam 202.

The objective lens 243 focuses the source beam 202 onto the sample 208. In an embodiment the objective lens 243 comprises a pole piece 132a, a control electrode 132b, a deflector 132c and an exciting coil 132d. In an embodiment a deflector, such as the deflector 132c or other deflectors in the objective lens 243 are configured to scan the source beam 202 across the surface of the sample 208. The detector array 240 is configured to detect signal electrons from the sample 208.

In an embodiment, the controller 150 is configured to control the electron-optical device 230. The controller 150 may be configured to control potentials applied to electrodes of electron-optical elements of the electron-optical device 230.

It can be challenging to implement charged particle-optical elements for multi-beam systems, particularly where the multi-beam contains many beams. It may be desirable, for example, to provide multi-beams having many thousands of beams. The pitch between beams of the multi-beam may be limited by the method of detecting the signal electrons (using a detector in proximity of the sample 208). For a smaller beam pitch, a smaller distance is required between the detector and the sample 208 in order to have sufficient detection efficiency and sufficiently low cross talk. As a consequence, charged particle-optical elements that operate on the multi-beam may need to become larger as the number of beams in the multi-beam increases. In a typical system having many thousands of beams, a region of a charged particle-optical element through which the multi-beam passes may need to be of the order of 10 mm across or larger for example in the range of 1 mm to 300 mm for example typically 2 to 20 mm. At the same time, physical features of the charged particle-optical elements may need to be very closely packed in order to operate on individual beams of the multi-beam in a desired way. This combination of factors can make fabrication difficult, have a negative impact on yield, and/or limit the number of beams that can be provided in the multi-beam. For the parallel plate deflectors discussed in the introduction, for example, individual plates may need to be very thin (e.g., having a smallest dimension of a few 10s of microns) and relatively long (e.g., having a largest dimension of 10mm or longer). It may be difficult to fabricate and/or coat such structures. The resulting structures may be relatively fragile, which may lead to low fabrication yield and/or vulnerability to failure. During manufacture of the structures, capillary forces may cause neighboring structures to stick to each other and/or otherwise cause damage to each other by contact. Environmental vibrations during manufacture may damage the structure. Strong control of environmental vibrations may be required during operation to achieve satisfactory performance. In a typical implementation, it may be necessary for example to control vibration amplitudes of features such as parallel plates to remain below a few nm. Closely spaced elements of the structure may need to be held at different electrical potentials (e.g., different rows of the parallel plate deflectors discussed in the introduction) from each other, leading to large electric fields. The large electric fields may increase a risk of electrical shorts and/or discharges, which may be caused for example by particle contamination. The large electric fields may cause elements to deform, which may reduce performance or need correcting for. Having many elements at different potentials requires complex wiring.

Embodiments of the present disclosure aim to address one or more the above challenges. At least some of these embodiments provide control of beams of a multi-beam by using tilted surfaces of tilted-surface plates to manipulate the beams.

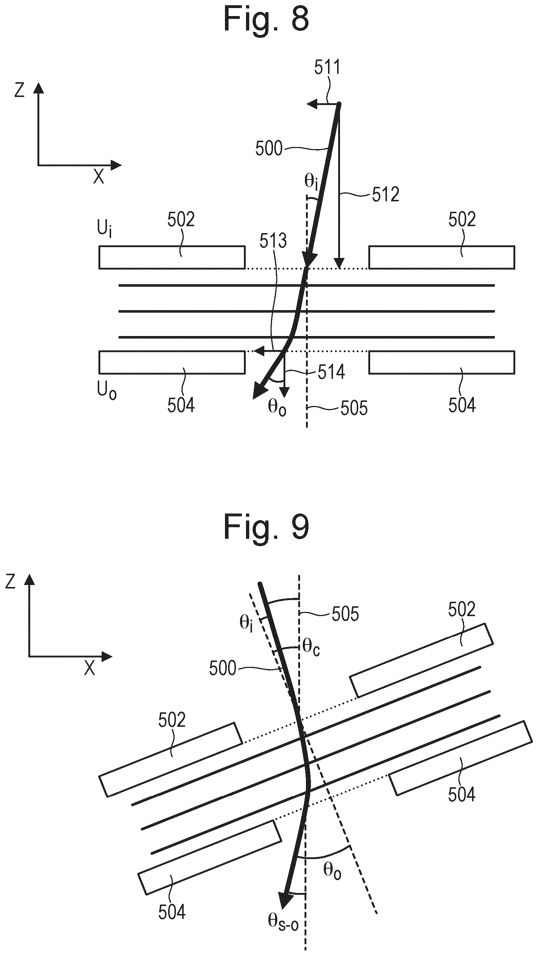

Principles of operation of the tilted-surface plates are now described with reference to Figure 8 and Figure 9. When a charged particle (e.g., an electron) enters a space with an electric field a force is exerted on the charged particle and the charged particle accelerates or decelerates. If the charged particle is propagating at an angle with respect to the electric field (i.e., not parallel to the electric field), the direction of propagation of the charged particle will change. This is illustrated schematically in Figure 8 where an example trajectory 500 of a charged particle is shown by the thicker line in the figure. Two parallel plates 502 and 504 are held at respective potentials $U_i$ and $U_o$ to define a uniform electric field between the plates. ($U_i$ is the potential of the upbeam electrode; $U_o$ is the potential applied to the downbeam electrode). The electric field is oriented vertically downwards in the plane of the page (in negative Z direction) and acts to decelerate the charged particle in the Z direction. The velocity of the charged particle upbeam of the electric field comprises an X component 511 and a Z component 512. The X component 511 and Z component 512 define an upbeam propagation angle $\theta_i$ of the charged particle relative to an optical axis 505. The velocity of the charged particle downbeam of the electric field comprises an X component 513 and a Z component 514. The X component 513 and the Z component 514 define a downbeam propagation angle $\theta_o$ relative to the optical axis 505. The deceleration of the charged particle along the Z direction causes the magnitude of the Z component 514 to be smaller than the magnitude of the Z component 512. The electric field has no component parallel to the X direction and does not therefore affect the velocity of the charged particle along the X direction. The X components 511 and 513 are thus identical. The reduction of the magnitude of the Z component 514 causes the downbeam propagation angle $\theta_o$ to be larger than an upbeam propagation angle $\theta_i$. The magnitude of the change in propagation angle, $|\theta_o - \theta_i|$, depends on the electric field strength. The change in angle can thus be controlled by controlling the potential difference between the plates 502 and 504.

For a paraxial beam (i.e., small propagation angles, e.g. small $\theta_i$ and $\theta_o$), the downbeam propagation angle $\theta_o$ is given by

$$\theta_o = \gamma \theta_i \qquad\qquad (1)$$

where $\gamma = \sqrt{U_i/U_o}$ is a proportionality parameter. This effect may be used to deflect a beam by a desired angle by introducing a tilt between the beam and the structure defining the electric field, as depicted schematically in Figure 9 where the structure defining the electric field comprises the parallel plates 502 and 504. Figure 9 shows that $\theta_i = \theta_c$, $-\theta_{s-i}$ and $\theta_o = \theta_{s-o} + \theta_c$, where: $\theta_{s-i}$ is the angle of the incoming beam with respect to the optical axis 505 of the system; $\theta_{s-o}$ is the angle of the outgoing beam with respect to the optical axis 505 of the system; and $\theta_c$ is the tilt angle of the decelerating structure. In the example shown, the angle between plates of the parallel plates 502 and 504 and the Z axis (which may be the same as the optical axis 505) may be referred to as a local inclination. Substituting this into equation (1) yields that the angle of the outgoing beam may be expressed as:

$$\theta_{s-o} = \gamma(\theta_c - \theta_{s-i}) - \theta_c \qquad\qquad (2)$$

Embodiments of the present disclosure provide an electron-optical element 520. The electron-optical element 520 may be a scan deflector array 260, for example as shown in Figure 3 or Figure 5, an electron-optical element of an alignment adjuster 290, for example as shown in Figure 4, or a deflector 132c, for example as shown in Figure 7.

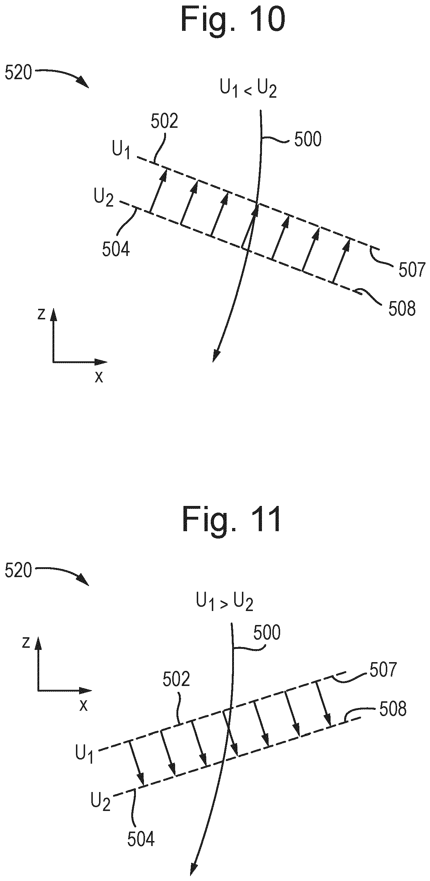

Figure 10 schematically depicts an electron-optical element 520. In an embodiment the electron-optical element 520 is configured to operate on a plurality of electron beams in a beam grid. For example, the electron-optical element 520 may be comprised in a scan deflector array 260, for example as shown in Figure 3 or Figure 5, or may be comprised in an alignment adjuster 290, for example as shown in Figure 4.

As shown in Figure 10, the electron-optical element 520 comprises a first surface 507 and a second surface 508. In an embodiment the first surface 507 has a plurality of apertures defined in it for allowing the beams to pass through. Similarly, the second surface 508 has a plurality of apertures defined in it for allowing the beams to pass through. The apertures may be beam apertures 266 defined in plates 261, for example as described above, and apertures in the first surface 507 are aligned with apertures in the second surface 508 such that beams may pass through the electron-optical element 520.

As shown in Figure 10, in an embodiment each of the first surface 507 and the second surface 508 is angled relative to a plane perpendicular to an axis of the beam grid. In Figure 10, the trajectory 500 of an electron is shown. In the orientation shown in Figure 10, the top of the drawing is the upbeam end. The bottom of the drawing is the downbeam end. The axis of the beam grid upbeam of the first surface 507 is substantially vertical (along the Z axis) in the orientation shown in Figure 10. The plane perpendicular to the axis of the beam grid is a horizontal plane (parallel to the X axis) into and out from the drawing, in the orientation shown in Figure 10. As shown in Figure 10, each of the first surface 507 and the second surface 508 is tilted relative to the horizontal direction.

As shown in Figure 10, in an embodiment the first surface 507 faces another surface of the electron-optical element 520. For example, in the arrangement shown in Figure 10, the first surface 507 faces the second surface 508 of the electron-optical element 520. A potential difference is applied between the first surface 507 and the surface (e.g. the second surface 508) that it faces.

Correspondingly, in an embodiment the second surface 508 faces another surface of the electron-optical element 520. For example, in the arrangement shown in Figure 10 the second surface 508 faces the first surface 507 of the electron-optical element 520 at a potential difference.

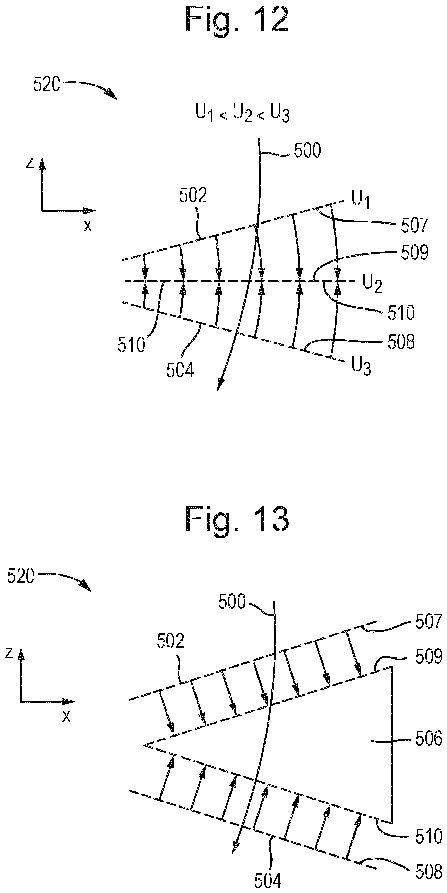

In the arrangement shown in Figure 10, the first surface 507 faces the second surface 508. That is, the surface that the first surface 507 faces is the second surface 508. The surface that the second surface 508 faces is the first surface 507. However, it is not essential for the first surface 507 to face the second surface 508. Figure 12 schematically depicts an alternative electron-optical element 520 in which the first surface 507 faces a surface different from the second surface 508, and the second surface 508 faces a surface different from the first surface 507.

By providing that each of the first surface 507 and the second surface 508 faces another surface at a potential difference, the electron-optical element 520 is configured to apply a deflection to the beams by controlling the potential difference. As shown in Figure 10 by the arrows between the first surface 507 and the second surface 508, an electric field is generated.

In an embodiment, each of the first surface 507 and the second surface 508 is connected to an electric power supply. The controller 150 may be configured to control the electric power supply to apply a controlled electric potential to each of the first surface 507 and the second surface 508. In an embodiment, each of the first surface 507 and the second surface 508 is connected to a respective electric power supply.

In the embodiment shown in Figure 10, a first potential $U_1$ is applied to the first surface 507. A second potential $U_2$ is applied to the second surface 508. The first potential $U_1$ is different from the second potential $U_2$. As indicated in Figure 10, in an embodiment the first potential $U_1$ is less than the second potential $U_2$. In an embodiment the controller 150 is configured to control the potential difference between the first surface 507 and the other surface (e.g. the second surface 508 in Figure 10) that the first surface 507 faces so as to accelerate the electrons.

Correspondingly, in an embodiment the controller 150 is configured to control the potential difference between the second surface 508 and the other surface (e.g. the first surface 507 in Figure 10) that the second surface 508 faces so as to accelerate the electrons. The configuration of the electron-optical element 520 shown in Figure 10 may be referred to as an accelerating configuration.

An embodiment of the invention is expected to achieve improved mechanical stability. The electron-optical element 520 may have higher mechanical stability compared to long, thin deflector bars. An embodiment of the invention is expected to make it easier to manufacture an electron-optical element for a deflector array and/or an alignment adjuster, for example. An embodiment of the invention is expected to reduce vibration of the electron-optical element during use of an electron-optical device comprising the electron-optical element.

An embodiment of the invention is expected to reduce the possibility of undesirable electrical breakdown. The distance between electrodes biased at different electric potentials is greater compared to for the long, thin deflector bars. The possibility of particle contamination leading to undesirable results is reduced.

In an embodiment, the first surface 507 is a surface of a first plate 502. The first plate 502 may have features of the plate 206 described with reference to Figure 2. In an embodiment, the second surface 508 is a surface of a second plate 504. The second plate 504 may have features of the plate 206 described with reference to Figure 2. The first plate 502 and the second plate 504 may be parallel plates.

An embodiment of the invention is expected to reduce undesirable deformations due to electrostatic forces. For example, the first plate 502 and the second plate 504 may have a sufficient thickness that the first surface 507 and the second surface 508 undergo substantially no deformation during use of the electron-optical element 520.

In an alternative embodiment, the thickness of the first plate 502 and/or the second plate 504 may be selected such that the first surface 507 and/or the second surface 508 deform due to electrostatic forces in a controlled manner. The deformation of the first surface 507 and/or the second surface 508 may be controlled so as to control the operation of the electron-optical element 520 on the beams.

In an embodiment, the controller 150 is configured to control application of a single electric potential to the first surface 507. The controller 150 may be configured to apply a single electric potential to the second surface 508. Only a single voltage per electrode (e.g. first surface 507 and second surface 508) is required to operate the electron-optical element 520. This is a reduction compared to the number of electrical connections required for the long, thin deflector bars. An embodiment of the invention is expected to simplify electrical connections of the electron-optical element 520.

In an embodiment, the deflection applied to the beams of the beam grid is dependent on an angle between the plane perpendicular to the axis of the beam grid and at least one of the first surface 507 and the second surface 508. In general, a greater angle of tilt may be expected to result in a greater angle of deflection of the beams.

In an embodiment, the controller 150 is configured to adjust the electric potential applied to the first surface 507 and/or the second surface 508 so as to control the strength of the electric field. By controlling the potential difference, the deflection applied to the beams may be controlled. The potential difference between the first surface 507 and the second surface 508 may be controlled without physically changing the position or orientation of the electron-optical element 520.

Figure 11 schematically depicts an alternative electron-optical element 520. Figure 11 shows an electron-optical element 520 with a decelerating configuration, whereas the electron-optical element shown in Figure 10 has an accelerating configuration.

As shown in Figure 11, in an embodiment the controller 150 is configured to control the potential difference between the first surface 507 and the other surface (e.g. the second surface 508 in Figure 11) that the first surface 507 faces so as to decelerate the electrons. Correspondingly, the controller 150 may be configured to control the potential difference between the second surface 508 and the other surface (e.g. the first surface 507 in Figure 11) that the second surface 508 faces so as to decelerate the electrons.

Figure 11 shows an arrangement in which the first potential $U_1$ applied to the first surface 507 is greater than the second potential $U_2$ applied to the second surface 508. The electric field between the first surface 507 and the second surface 508 decelerate the electrons of the beams.

As shown in Figure 10 and Figure 11, for example, in an embodiment each of the first surface 507 and the second surface 508 is substantially parallel to the other surface that it faces. For example, the first surface 507 and the second surface 508 may be substantially parallel to each other.

However, it is not essential for each of the first surface 507 and the second surface 508 to be substantially parallel to the other surface that it faces. Figure 12 schematically depicts an alternative electron-optical element 520. As shown in Figure 12, in an embodiment the first surface 507 is not parallel to the other surface that it faces. Similarly, the second surface 508 is not parallel to the other surface that it faces.

In the arrangement shown in Figure 12, the electron-optical element 520 comprises a third surface 509 and a fourth surface 510. As shown in Figure 12, in an embodiment the third surface has a plurality of apertures defined in it for allowing the beams to pass through. The fourth surface 510 has a plurality of apertures defined in it for allowing the beams to pass through. The apertures may be beam apertures 266, for example as described with reference to Figure 2.

Each of the third surface 509 and the fourth surface 510 faces another surface of the electron-optical element 520 at a potential difference. The electron-optical element 520 is configured to apply a deflection to the beams by controlling the potential difference.

For example, in the arrangement shown in Figure 12 the first surface 507 and the third surface 509 face each other. The second surface 508 and the fourth surface 510 face each other. In the arrangement shown in Figure 12, a first potential $U_1$ is applied to the first surface 507. A second potential $U_2$ is applied to the third surface 509. In an embodiment, the same second potential $U_2$ is applied to the fourth surface 510. A third potential $U_3$ is applied to the second surface 508. In an embodiment, the third surface 509 and the fourth surface 510 are at substantially the same potential.

In an alternative embodiment, the third surface 509 and the fourth surface 510 may have different potentials applied to them. By providing that the third surface 509 and the fourth surface 510 are at substantially the same potential, the number of different potentials required to be controlled may be reduced. For example, in an embodiment the third surface 509 and the fourth surface 510 are at opposing sides of a plate located between the first surface 507 and the second surface 508.

As shown in Figure 12, in an embodiment the first potential $U_1$ is less than the second potential $U_2$. The potential difference between the first surface 507 and the third surface 509 causes an electric field between the first surface 507 and the third surface 509 that may decelerate the electrons. The second potential $U_2$ may be less than the third potential $U_3$. The potential difference between the fourth surface 510 and the second surface 508 may lead to the generation of an electric field between the fourth surface 510 and the second surface 508 that accelerates the electrons.

As shown in Figure 12, in an embodiment the electron-optical element 520 is configured to generate an electric field that decelerates the electrons and another electric field that accelerates the electrons. In an embodiment the controller 150 is configured to control deflection of the beams by controlling the second potential $U_2$.

In an embodiment the controller 150 is configured to apply substantially the same potential to the first surface 507 and the second surface 508 such that the electron-optical element 520 substantially maintains an energy of the beams that pass through the electron-optical element 520. For example, in the arrangement shown in Figure 12, the first potential $U_1$ may be made to be substantially equal to the third potential $U_3$. In an embodiment the controller 150 is configured to control deflection of the beams by adjusting the second potential $U_2$ while keeping the energy of the incoming and outgoing beams the same.

Figure 13 schematically depicts an alternative electron-optical element 520. In the embodiment shown in Figure 13, the third surface 509 and the fourth surface 510 are at opposing sides of a plate 506. The plate 506 is located between the first surface 507 and the second surface 508. In an embodiment the controller 150 is configured to apply an electric potential to the plate 506 such that the third surface 509 and the fourth surface 510 are at substantially the same potential.

As shown in Figure 10, Figure 11 and Figure 13, in an embodiment each of the first surface 507 and the second surface 508 is substantially uniformly distanced from the other surface that it faces. For example, in Figure 10 and Figure 11, the first surface 507 and the second surface 508 are substantially uniformly distanced from each other. The distance between the first surface 507 and the second surface 508 does not significantly change across the beam grid (e.g. in the X-direction in the Figures). In the arrangement shown in Figure 13, the first surface 507 and the third surface 509 may be substantially uniformly distanced from each other. The fourth surface 510 and the second surface 508 may be substantially uniformly distanced from each other.

By providing substantially uniform distance between the surfaces, the electron-optical element 520 may apply a substantially uniform deflection to a plurality of beams of the beam grid. Undesirable variation in deflection of the beams may be reduced. An embodiment of the invention is expected to increase uniformity of a deflection applied to beams of a beam grid. The electric field strength between the surfaces may be substantially uniform in a direction across the beams.

However, it is not essential for the distance between the surfaces to be uniform. For example, Figure 12 depicts an embodiment in which the distance between the first surface 507 and the third surface 509 varies in a direction across the beams. Similarly, the distance between the fourth surface 510 and the second surface 508 varies in a direction across the beams.

As shown in Figure 13, in an embodiment at least one of the third surface 509 and the fourth surface 510 is angled relative to the plane perpendicular to the axis of the beam grid. For example, in the arrangement of Figure 13, both the third surface 509 and the fourth surface 510 are angled relative to the plane perpendicular to the axis of the beam grid. In an alternative arrangement, one of the third surface 509 and the fourth surface 510 is angled relative to the plane perpendicular to the axis of the beam grid, while the other may be substantially parallel to the plane.

It is not essential for the third surface 509 and the fourth surface 510 to be tilted. For example, Figure 12 schematically depicts an arrangement in which the third surface 509 and the fourth surface 510 are substantially parallel to the plane perpendicular to the axis of the beam grid.

In an embodiment, the apertures in the facing surfaces are aligned so as to allow the beams to pass through substantially without blocking electrons of the beams. The alignment of the apertures may take into account the expected deflection of the beams.

In an embodiment, the apertures have a size that is larger than the respective beams. This may help to reduce the possibility of electrons of the beams being undesirably blocked by the surfaces. In an embodiment, the size of the apertures is selected so as to take into account any displacement that accompanies the deflection of the beams. For example, in an embodiment the apertures are slits. The aperture may have a longer dimension in one direction in the X-Y plane compared to in an orthogonal direction in the X-Y plane. By providing the longer dimension, a range of different deflections may be accommodated without undesirably blocking electrons of the beams. For example, in an embodiment each slit (i.e. aperture) has a longer dimension arranged in a direction to accommodate a varying deflection of the beam. For example, in the embodiments shown in Figure 10, Figure 11, Figure 12, and Figure 13, the deflection of the beams may be substantially in the X-direction. The slits may have a longer dimension in the X-direction compared to in the Y-direction. The location of the beam may depend on an upbeam deflection of the beam. The deflection may be varied, for example by controlling the potential difference between surfaces. When the deflection is varied, the location of the beam downbeam of the deflection may vary. By providing that the apertures are slits, the slit may allow the passage of the beam over a range of deflections.

In an embodiment the electron-optical element 520 comprises at least one actuator configured to adjust a tilt of at least one of the first surface 507 and the second surface 508 relative to a direction substantially parallel to the deflection of the beams, e.g. relative to a plane perpendicular to the electron-optical axis, e.g. the X-Y plane. For example, the actuator may be configured to tilt the first surface 507 and/or the second surface 508 relative to the X-Y plane. In an embodiment the electron-optical element 520 comprises at least one actuator configured to displace at least one of the first surface 507 and the second surface 508 along a direction substantially parallel to the deflection of the beams. For example, the actuator may be configured to displace the first surface 507 and/or the second surface 508 along the X-direction. The actuator may be configured to dynamically tilt and/or displace one or more plates 502, 504 within the electron-optical element 520. By tilting and/or displacing the surfaces, the electron-optical element 520 may be configured to allow for a greater range of different deflections, without unduly increasing the risk of electrons being undesirably blocked. In an embodiment the actuator comprises a piezoelectric actuator. Other types of actuator may be used.

An embodiment of the invention is expected to allow for deflection to be controlled without unduly increasing the risk of obstructing electrons.

As shown in Figure 10, Figure 11, Figure 12 and Figure 13, in an embodiment at least one of the first surface 507 and the second surface 508 is substantially planar. As shown in Figure 10 and Figure 11, in an embodiment each of the first surface 507 and the second surface 508 is substantially planar. As shown in Figure 12 and Figure 13, in an embodiment each of the first surface 507, the second surface 508, the third surface 509 and the fourth surface 510 is substantially planar. The surfaces may have shapes that are slightly different from exactly planar. For example, during use of the electron-optical element 520, one or more of the surfaces may deform due to electrostatic forces. Such deformation may be undesirable. Alternatively, such deformation may be desirably controlled so as to apply a desirable function to the beams that pass through the electron-optical element 520.

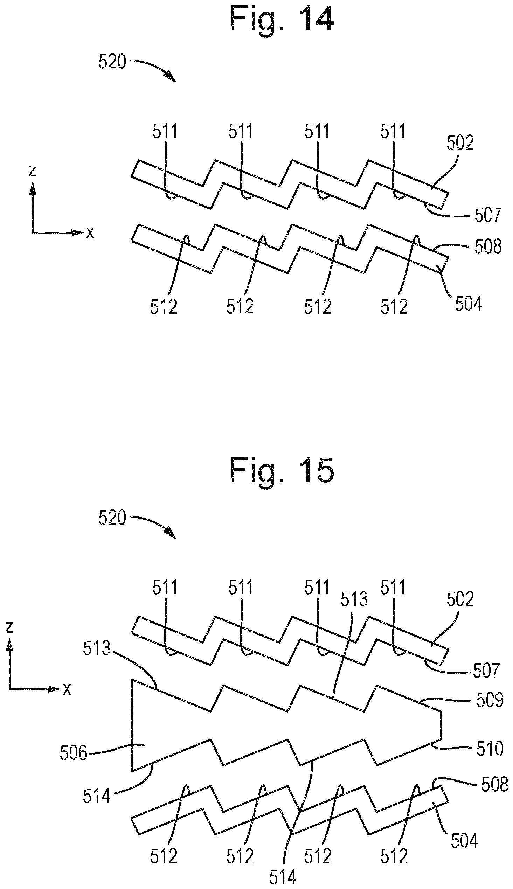

Figure 14 schematically depicts an alternative electron-optical element 520. As shown in Figure 14, in an embodiment at least one of the first surface 507 and the second surface 508 comprises a plurality of parallel regions 511, 512 electrically connected to each other across the beam grid. For example, the first surface 507 shown in Figure 14 comprises a plurality of parallel regions 511. The parallel regions 511 may be electrically connected to each other. A single electric potential may be applied to substantially all of the parallel regions 511. Similarly, the second surface 508 may comprise a plurality of parallel regions 512 electrically connected to each other across the beam grid. A single electric potential may be applied to the parallel regions 512 of the second surface 508.

For example, the electron-optical element 520 may function similarly to the electron-optical element 520 shown in Figure 10. A first potential $U_1$ may be applied to the parallel regions 511 of the first surface 507. A second potential $U_2$ may be applied to the parallel regions 512 of the second surface 508. The first potential $U_1$ may be less than the second potential $U_2$ such that the electric field generated between the first surface 507 and the second surface 508 accelerates the electrons.

In an embodiment, each of the parallel regions 511, 512 may have a long thin shape, i.e. extending in a longitudinal direction along the Y-axis and a shorter way along the X-direction. Each parallel region 511, 512 is tilted relative to the X-Y plane, i.e. the plane perpendicular to the axis of the beam grid. In an embodiment, all of the parallel regions 511 within the same surface are tilted at the same angle.

The arrangement shown in Figure 14 may be substantially analogous to the arrangement shown in Figure 10, but with the first surface 507 and the second surface 508 broken up into the parallel regions 511, 512, respectively. By providing the plurality of parallel regions 511, 512 (instead of a single planar surface as in Figure 10), the extent of the first surface 507 and the second surface 508 in the Z-direction (i.e. a direction parallel to the axis of the beam grid) may be reduced. An embodiment of the invention is expected to reduce the volume taken up by the electron-optical element 520 within an electron-optical device comprising the electron-optical element 520.

As shown in Figure 14, the first surface 507 may be provided as a surface of a first plate 502. The second surface 508 may be provided as a surface of a second plate 504. In the arrangement shown in Figure 14, the upbeam facing surface of the first plate 502 has substantially the same shape as the first surface 507. The downbeam facing surface of the second plate 504 has substantially the same shape as the second surface 508. In an alternative embodiment, the upbeam facing surface of the first plate 502 may be substantially planar, for example parallel to the X-Y plane. The downbeam facing surface of the second plate 504 may be substantially planar, for example parallel to the X-Y plane.

The electron-optical element 520 shown in Figure 14 may have an accelerating configuration. Alternatively, it may have a decelerating configuration.

There are discontinuities between adjacent parallel regions 511, 512. Adjacent parallel regions 511, 512 may be distanced from each other in the z-direction. In an embodiment the parallel regions 511, 512 have a dimension in the x-direction greater than the distance in the z-direction between adjacent parallel regions 511, 512. For example, the dimension in the x-direction parallel regions 511, 512 may be at least two times, optionally at least five times, optionally at least 10 times, optionally at least 20 times and optionally at least 50 times greater than the distance in the z-direction between adjacent parallel regions 511, 512. In an embodiment the parallel regions 511, 512 have a dimension in the y-direction greater than the distance in the z-direction between adjacent parallel regions 511, 512. For example, the dimension in the y-direction parallel regions 511, 512 may be at least two times, optionally at least five times, optionally at least 10 times, optionally at least 20 times and optionally at least 50 times greater than the distance in the z-direction between adjacent parallel regions 511, 512. By providing that the distance between the parallel regions 511, 512 in the z direction is substantially smaller than the width of the parallel regions 511, 512 in the x / y direction, undesired aberrations due to the discontinuities between adjacent parallel regions 511, 512 may be reduced.

Figure 15 schematically depicts an alternative electron-optical element 520. As shown in Figure 15, the electron-optical element 520 may comprise a first surface 507 facing a third surface 509, and a second surface 508 facing a fourth surface 510. Two different electric fields may be generated between the two pairs of facing surfaces, similar to as in the arrangement depicted in Figure 13, for example.

The embodiment shown in Figure 15 may function analogously to the embodiment depicted in Figure 13, albeit with the surfaces broken up into respective parallel regions. For example, in Figure 15 the first surface 507 comprises a plurality of parallel regions 511. The third surface 509 comprises a plurality of parallel regions 513. The fourth surface 510 comprises a plurality of parallel regions 514. The second surface 508 comprises a plurality of parallel regions 512. By providing the parallel regions, the electron-optical element 520 shown in Figure 15 may perform the functions of the electron-optical element 520 shown in Figure 13, with a reduced physical extent in the Z-direction.

As shown in Figure 3, Figure 4 or Figure 5, for example, in an embodiment the electron-optical element is comprised in an electron-optical device 230. The electron-optical device 230 may comprise an objective lens array 241. The objective lens array 241 may be configured to focus the electron beams onto the sample 208.

In an embodiment the controller 150 is configured to control at least one potential difference associated with the objective lens array 241 so as to compensate for any defocussing caused by the electron-optical element 520. For example, when the electron-optical element 520 is used as a deflector array 260 (for example as shown in Figure 3 or Figure 5), it is possible that the deflector array 260 may have a lensing effect on the electron beams in addition to the desired deflection. Such a lensing (e.g. focussing) effect may be caused due to the non-zero extent of the through holes in the plates 502, 504, 506. This may lead to defocussing of the beams. The defocussing may be common to the beams. Such defocussing may be compensated by adjusting potentials within the objective lens array 241.

For example, in an embodiment the controller 150 is configured to control an electric potential applied to a most upbeam electrode of the objective lens array 241 so as to compensate for any defocussing caused by the electron-optical element 520.

As shown in Figure 3 and Figure 5, in an embodiment the electron-optical element 520 may be provided as a deflector array 260. In an embodiment the controller 150 is configured to apply a varying potential difference (i.e. between facing surfaces of the electron-optical element) for scanning the beams over a sample surface. In an embodiment the deflector array 260 is configured to deflect the beams in one direction within the X-Y plane (i.e. the plane perpendicular to the electron-optical axis of the electron-optical device 230). In an embodiment the controller 150 is configured to control the stage 209 to move the sample 208 so as to provide a scanning movement in a different direction, for example a direction orthogonal to the scanning direction of the deflector array 260.

As shown in Figure 4, for example, in an embodiment the electron-optical device 230 comprises a pair of the electron-optical element 520 configured to adjust alignment of the beam grid in a direction perpendicular to the axis of the beam grid. The electron-optical element 520 may function as an alignment adjuster 290. The alignment adjuster 290 may comprise a pair of the electron-optical element shown in Figure 10, Figure 11, Figure 12, Figure 13, Figure 14 or Figure 15, for example. The upbeam electron-optical element of the alignment adjuster 290 may deflect the beams in one direction in the X-Y plane. The downbeam electron-optical element of the alignment adjuster 290 may deflect the beams in the opposite direction. In an embodiment, the alignment adjuster 290 is configured such that the direction of the beams is substantially the same downbeam of the alignment adjuster 290 as upbeam of the adjuster 290. The alignment adjuster 290 shifts the beam in the X-Y plane.

In an embodiment the electron-optical element 520 may be provided as a deflector array 260 and also as a component of an alignment adjuster 290.

**EP 4 749 679 A1**

As shown in Figure 3, Figure 4 and Figure 5, for example, in an embodiment the electron-optical element 520 is provided within a multi-beam electron-optical apparatus 140. As shown in Figure 7, in an alternative embodiment a single beam electron-optical apparatus 140 comprises the electron-optical element 520 as a deflector 132c. In the context of a single beam electron-optical apparatus 140, the surfaces 507, 508, 509, 510 may have a single aperture rather than a plurality of apertures.

Embodiments of the invention are described in the following numbered clauses:

Clause 1: a charged particle-optical element configured to operate on a plurality of charged particle beams in a beam grid, the charged particle-optical element comprising:
a first surface and a second surface, wherein each of the first surface and the second surface:

has a plurality of apertures defined in it for allowing the beams to pass through,
is angled relative to a plane perpendicular to an axis of the beam grid; and
faces another surface of the charged particle-optical element at a potential difference, such that the charged particle-optical element is configured to apply a deflection to the beams by controlling the potential difference.

Clause 2: the charged particle-optical element of clause 1, configured such that the deflection applied to the beams of the beam grid is dependent on an angle between the plane perpendicular to the axis of the beam grid and at least one of the first surface and the second surface.

Clause 3: the charged particle-optical element of clause 1 or 2, wherein each of the first surface and the second surface is substantially parallel to the other surface that it faces.

Clause 4: the charged particle-optical element of any preceding clause, wherein the first surface faces the second surface.

Clause 5: the charged particle-optical element of any preceding clause, wherein at least one of the first surface and the second surface is substantially planar.

Clause 6: the charged particle-optical element of any preceding clause, wherein at least one of the first surface and the second surface comprises a plurality of parallel regions electrically connected to each other across the beam grid.

Clause 7: the charged particle-optical element of any preceding clause, wherein each of the first surface and the second surface is substantially uniformly distanced from the other surface that it faces.

Clause 8: the charged particle-optical element of any preceding clause, comprising:
a third surface and a fourth surface, wherein each of the third surface and the fourth surface:

has a plurality of apertures defined in it for allowing the beams to pass through; and
faces another surface of the charged particle-optical element at a potential difference, such that the charged particle-optical element is configured to apply a deflection to the beams by controlling the potential difference.

Clause 9: the charged particle-optical element of clause 8, wherein at least one of the third surface and the fourth surface is angled relative to the plane perpendicular to the axis of the beam grid.

Clause 10: the charged particle-optical element of clause 8 or 9, wherein the first surface faces the third surface and the second surface faces the fourth surface.

Clause 11: the charged particle-optical element of any of clauses 8-10, wherein the third surface and the fourth surface are at opposing sides of a plate located between the first surface and the second surface, such that the third surface and the fourth surface are at substantially the same potential.

Clause 12: the charged particle-optical element of any preceding clause, wherein the apertures are slits.

Clause 13: the charged particle-optical element of clause 12, wherein each slit has a longer dimension arranged in a direction to accommodate a varying deflection of the beam.

Clause 14: the charged particle-optical element of any preceding clause, comprising:
at least one actuator configured to adjust a tilt of at least one of the first surface and the second surface relative to a direction substantially parallel to the deflection of the beams.

Clause 15: a charged particle-optical device for projecting a plurality of charged particle beams in a beam grid towards a sample, the device comprising the charged particle-optical element of any preceding clause.

Clause 16: the charged particle-optical device of clause 15, comprising:
a controller configured to control the potential difference applied between facing surfaces of the charged particle-optical element.

Clause 17: the charged particle-optical device of clause 16, wherein the controller is configured to control the potential difference between the first surface and the other surface that the first surface faces so as to accelerate the charged particles.

Clause 18: the charged particle-optical device of clause 16, wherein the controller is configured to control the potential

15

difference between the first surface and the other surface that the first surface faces so as to decelerate the charged particles.

Clause 19: the charged particle-optical device of clause 16 or 17, wherein the controller is configured to control the potential difference between the second surface and the other surface that the second surface faces so as to decelerate the charged particles.

Clause 20: the charged particle-optical device of any of clauses 16 to 19, wherein the controller is configured to apply substantially the same potential to the first surface and the second surface such that the charged particle-optical element substantially maintains an energy of the beams that pass through the charged particle-optical element.

Clause 21: the charged particle-optical device of any of clauses 16 to 20, comprising:

an objective lens array configured to focus the charged particle beams onto the sample;
wherein the controller is configured to control at least one potential difference associated with the objective lens array so as to compensate for any defocusing caused by the charged particle-optical element.

Clause 22: the charged particle-optical device of clause 21, wherein the controller is configured to control an electric potential applied to a most upbeam electrode of the objective lens array so as to compensate for any defocusing caused by the charged particle-optical element.

Clause 23: the charged particle-optical device of any of clauses 15 to 22, wherein the controller is configured to apply a varying potential difference for scanning the beams over a sample surface.

Clause 24: the charged particle-optical device of any of clauses 15 to 23, comprising a pair of the charged particle-optical element configured to adjust alignment of the beam grid in a direction perpendicular to the axis of the beam grid.

Clause 25: the charged particle-optical device of clause 24, comprising two pairs of the charged particle-optical element, each pair configured to adjust alignment of the beam grid in a respective direction perpendicular to the axis of the beam grid.

Clause 26: a method of projecting a plurality of charged particle beams in a beam grid towards a sample, the method comprising:
operating on the beams with a charged particle-optical element comprising first surface and a second surface, wherein each of the first surface and the second surface:

has a plurality of apertures defined in it for allowing the beams to pass through,
is angled relative to a plane perpendicular to an axis of the beam grid; and
faces another surface of the charged particle-optical element at a potential difference; and
applying a deflection to beams of the beam grid by controlling the potential difference.

Clause 27: a charged particle-optical element configured to operate on a charged particle beam, the charged particle-optical element comprising:
a first surface and a second surface, wherein each of the first surface and the second surface:

has apertures defined in it for allowing the beam to pass through,
is angled relative to a plane perpendicular to an axis of the beam; and
faces another surface of the charged particle-optical element at a potential difference, such that the charged particle-optical element is configured to apply a deflection to the beam by controlling the potential difference.

Clause 28: the charged particle-optical element of clause 27, wherein each of the first surface and the second surface is substantially parallel to the other surface that it faces.

Clause 29: the charged particle-optical element of clause 27 or 28, wherein the first surface faces the second surface.

Clause 30: the charged particle-optical element of any of clauses 27 to 29, wherein at least one of the first surface and the second surface is substantially planar.

Clause 31: the charged particle-optical element of any of clauses 27 to 30, wherein each of the first surface and the second surface is substantially uniformly distanced from the other surface that it faces.

Clause 32: the charged particle-optical element of any of clauses 27 to 31, comprising:
a third surface and a fourth surface, wherein each of the third surface and the fourth surface:

has an aperture defined in it for allowing the beam to pass through; and
faces another surface of the charged particle-optical element at a potential difference, such that the charged particle-optical element is configured to apply a deflection to the beam by controlling the potential difference.

Clause 33: the charged particle-optical element of clause 32, wherein at least one of the third surface and the fourth surface is angled relative to the plane perpendicular to the axis of the beam.

Clause 34: the charged particle-optical element of clause 32 or 33, wherein the first surface faces the third surface and the second surface faces the fourth surface.

Clause 35: the charged particle-optical element of any of clauses 32 to 34, wherein the third surface and the fourth surface are at opposing sides of a plate located between the first surface and the second surface, such that the third surface and the fourth surface are at substantially the same potential.

Clause 36: the charged particle-optical element of any of clauses 27 to 35, wherein the aperture is a slit.

Clause 37: the charged particle-optical element of clause 36, wherein the slit has a longer dimension arranged in a direction to accommodate a varying deflection of the beam.

Clause 38: a charged particle-optical device for projecting a charged particle beam towards a sample, the device comprising the charged particle-optical element of any of clauses 27 to 37.

Clause 39: the charged particle-optical device of clause 38, comprising:

a controller configured to control the potential difference applied between facing surfaces of the charged particle-optical element.

Clause 40: the charged particle-optical device of clause 39, wherein the controller is configured to control the potential difference between the first surface and the other surface that the first surface faces so as to accelerate the charged particles.

Clause 41: the charged particle-optical device of clause 39, wherein the controller is configured to control the potential difference between the first surface and the other surface that the first surface faces so as to decelerate the charged particles

Clause 42: the charged particle-optical device of clause 39 or 40, wherein the controller is configured to control the potential difference between the second surface and the other surface that the second surface faces so as to decelerate the charged particles.

Clause 43: the charged particle-optical device of any of clauses 39 to 42, wherein the controller is configured to apply substantially the same potential to the first surface and the second surface such that the charged particle-optical element substantially maintains an energy of the beam that passes through the charged particle-optical element.

Clause 44: the charged particle-optical device of any of clauses 39 to 43, comprising:

an objective lens configured to focus the charged particle beam onto the sample;

wherein the controller is configured to control at least one potential difference associated with the objective lens so as to compensate for any defocusing caused by the charged particle-optical element.

Clause 45: the charged particle-optical device of any of clauses 38 to 44, wherein the controller is configured to apply a varying potential difference for scanning the beam over a sample surface.

Clause 46: the charged particle-optical device of any of clauses 38 to 45, comprising a pair of the charged particle-optical element configured to adjust alignment of the beam in a direction perpendicular to the axis of the beam.

Clause 47: the charged particle-optical device of clause 46, comprising two pairs of the charged particle-optical element, each pair configured to adjust alignment of the beam in a respective direction perpendicular to the axis of the beam.

Clause 48: a method of projecting a charged particle beam towards a sample, the method comprising: operating on the beam with a charged particle-optical element comprising a first surface and a second surface, wherein each of the first surface and the second surface:

has an aperture defined in it for allowing the beam to pass through,

is angled relative to a plane perpendicular to an axis of the beam; and

faces another surface of the charged particle-optical element at a potential difference; and

applying a deflection to beam by controlling the potential difference.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A charged particle-optical element configured to operate on a plurality of charged particle beams in a beam grid, the charged particle-optical element comprising:

a first surface and a second surface, wherein each of the first surface and the second surface:

has a plurality of apertures defined in it for allowing the beams to pass through,
is angled relative to a plane perpendicular to an axis of the beam grid; and
faces another surface of the charged particle-optical element at a potential difference, such that the charged particle-optical element is configured to apply a deflection to the beams by controlling the potential difference.

2. The charged particle-optical element of claim 1, configured such that the deflection applied to the beams of the beam grid is dependent on an angle between the plane perpendicular to the axis of the beam grid and at least one of the first surface and the second surface.

3. The charged particle-optical element of claim 1 or 2, wherein each of the first surface and the second surface is substantially parallel to the other surface that it faces.

4. The charged particle-optical element of any preceding claim, wherein the first surface faces the second surface.

5. The charged particle-optical element of any preceding claim, wherein at least one of the first surface and the second surface is substantially planar.

6. The charged particle-optical element of any preceding claim, wherein at least one of the first surface and the second surface comprises a plurality of parallel regions electrically connected to each other across the beam grid..

7. The charged particle-optical element of any preceding claim, comprising:
a third surface and a fourth surface, wherein each of the third surface and the fourth surface:

has a plurality of apertures defined in it for allowing the beams to pass through; and
faces another surface of the charged particle-optical element at a potential difference, such that the charged particle-optical element is configured to apply a deflection to the beams by controlling the potential difference.

8. The charged particle-optical element of claim 7, wherein at least one of the third surface and the fourth surface is angled relative to the plane perpendicular to the axis of the beam grid.

9. The charged particle-optical element of claim 7 or 8, wherein the first surface faces the third surface and the second surface faces the fourth surface, and wherein the third surface and the fourth surface are at opposing sides of a plate located between the first surface and the second surface, such that the third surface and the fourth surface are at substantially the same potential.

10. The charged particle-optical element of any preceding claim, wherein the apertures are slits, and wherein each slit has a longer dimension arranged in a direction to accommodate a varying deflection of the beam.

11. A charged particle-optical device for projecting a plurality of charged particle beams in a beam grid towards a sample, the device comprising the charged particle-optical element of any preceding claim.

12. The charged particle-optical device of claim 11, comprising:
a controller configured to control the potential difference applied between facing surfaces of the charged particle-optical element.

13. The charged particle-optical device of any of claims 11 and 12, comprising:

an objective lens array configured to focus the charged particle beams onto the sample;
wherein the controller is configured to control at least one potential difference associated with the objective lens array so as to compensate for any defocusing caused by the charged particle-optical element.

14. The charged particle-optical device of any of claims 11 to 13, wherein the controller is configured to apply a varying potential difference for scanning the beams over a sample surface.

15. The charged particle-optical device of any of claims 11 to 14, comprising two pairs of the charged particle-optical element, each pair configured to adjust alignment of the beam grid in a respective direction perpendicular to the axis of

the beam grid.

# Fig. 1

# Fig. 2

# Fig. 3

# Fig. 4

# Fig. 5

# Fig. 6

# Fig. 7

# Fig. 8

# Fig. 9

# Fig. 10

520

$U_1 < U_2$

502

500

$U_1$

$U_2$

504

507

508

Z

X

# Fig. 11

520

$U_1 > U_2$

500

Z

X

502

507

508

$U_1$

$U_2$

504

## Fig. 12

520

$U_1 < U_2 < U_3$

500

Z

X

502

507

509

$U_1$

$U_2$

510

510

508

504

$U_3$

## Fig. 13

520

500

507

509

502

Z

X

506

510

508

504

# Fig. 14

520

511 511 511 511 502

Z

X

507

508

512 512 512 512 504

# Fig. 15

520

511 511 511 513 511 502

Z

513

X

507

509

506

510

514

508

512 512 512 512 504

514

Europäisches
Patentamt

European
Patent Office

Office européen
des brevets

# EUROPEAN SEARCH REPORT

**Application Number**

EP 24 21 4067

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/066036 A1 (GODET LUDOVIC [US] ET AL) 4 March 2021 (2021-03-04)<br><br>* figs. 2 to 5, 7 to 9 and related text; paragraphs [0035] - [0044] *<br>----- | 1,2,4, 6-9,11, 12 | INV.<br>H01J37/147 |
| X | JP 2003 133252 A (SEMICONDUCTOR ENERGY LAB) 9 May 2003 (2003-05-09)<br>* abstract; figures 1,2 *<br>----- | 1-3,5,7, 8,11,12 | |
| Y | US 2020/185201 A1 (KURUNCZI PETER F [US] ET AL) 11 June 2020 (2020-06-11)<br>* figs. 1 to 3 and related text; paragraph [0040] *<br>----- | 1-9,11, 12,15 | |
| X | US 2016/071693 A1 (BILOIU COSTEL [US] ET AL) 10 March 2016 (2016-03-10)<br>* figs. 1, 2, 5, 7, 8 and related text; paragraphs [0045], [0042], [0066] *<br>----- | 1-9,11, 12,15 | |
| X | WO 2023/197125 A1 (HUAWEI TECH CO LTD [CN]) 19 October 2023 (2023-10-19)<br><br>* abstract; figures 4, 6-15, 17-20 *<br>* page 12 *<br>----- | 1,2,4, 6-9,11, 12,14 | TECHNICAL FIELDS SEARCHED (IPC)<br><br>H01J |
| Y | US 2019/237292 A1 (PARK JONGCHUL [KR]) 1 August 2019 (2019-08-01)<br>* figs. 7 to 11, 13 to 17 and related text *<br>----- | 1-9,11, 12,15 | |
| X | US 4 334 169 A (TAKENAKA SHIGEO ET AL) 8 June 1982 (1982-06-08)<br>* fig. 7 and related text *<br>----- | 1,2,4,7 | |
| X | US 4 701 678 A (BLACKER ALLEN P [US] ET AL) 20 October 1987 (1987-10-20)<br>* figs. 5 to 8 and related text *<br>----- | 1,2,4-8 | |
| | -/-- | | |

The present search report has been drawn up for all claims

| Place of search | Date of completion of the search | Examiner |
|---|---|---|
| Munich | 4 August 2025 | Krauss, Jan |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

...........................................................................
& : member of the same patent family, corresponding
document

EPO FORM 1503 03.82 (P04C01)

Europäisches
Patentamt

European
Patent Office

Office européen
des brevets

# EUROPEAN SEARCH REPORT

**Application Number**

**EP 24 21 4067**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP S53 153856 U (?) 4 December 1978 (1978-12-04) * abstract; figure 1 * ----- | 1,2,4,7 | |

TECHNICAL FIELDS
SEARCHED (IPC)

The present search report has been drawn up for all claims

| Place of search | Date of completion of the search | Examiner |
|---|---|---|
| Munich | 4 August 2025 | Krauss, Jan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# EP 4 749 679 A1

| Europäisches Patentamt<br>European Patent Office<br>Office européen des brevets | | **Application Number**<br><br>EP 24 21 4067 |

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

    see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☒ Only part of the further search fees have been paid within the fixed time limit. The present European search report has been drawn up for those parts of the European patent application which relate to the inventions in respect of which search fees have been paid, namely claims:

    1-9, 11, 12, 14, 15

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**

**SHEET B**

Application Number

EP 24 21 4067

The Search Division considers that the present European patent application does not comply with the requirements of unity of invention and relates to several inventions or groups of inventions, namely:

        1. claims: 1-9, 11, 12

            directed to a charged particle optical element wherein the
            deflection applied to the beams of the beam grid is
            dependent on an angle between the plane perpendicular to the
            axis of the beam grid and at least one of the first surface
            and the second surface as defined in claim 2
                            ---

        2. claim: 10

            directed to a charged particle optical element wherein the
            apertures are slits as defined in claim 10
                            ---

        3. claim: 13

            directed to a charged particle optical device with an
            objective lens array as defined in claim 13
                            ---

        4. claims: 14, 15

            directed to a charged particle optical device wherein the
            controller is configured to apply a varying potential
            difference for scanning the beams over a sample surface as
            defined in claim 14 or with the apparently corresponding
            features of claim 15
                            ---

# EP 4 749 679 A1

## ANNEX TO THE EUROPEAN SEARCH REPORT
## ON EUROPEAN PATENT APPLICATION NO.

EP 24 21 4067

04-08-2025

| Patent document cited in search report | Publication date | Patent family member(s) | Publication date |
|---|---|---|---|
| US 2021066036 A1 | 04-03-2021 | CN 113196123 A | 30-07-2021 |
| | | CN 113196442 A | 30-07-2021 |
| | | CN 113227859 A | 06-08-2021 |
| | | CN 113242989 A | 10-08-2021 |
| | | EP 3899614 A1 | 27-10-2021 |
| | | EP 3899615 A1 | 27-10-2021 |
| | | EP 3899617 A1 | 27-10-2021 |
| | | EP 3900008 A1 | 27-10-2021 |
| | | JP 7410951 B2 | 10-01-2024 |
| | | JP 7447118 B2 | 11-03-2024 |
| | | JP 7447119 B2 | 11-03-2024 |
| | | JP 7555340 B2 | 24-09-2024 |
| | | JP 2022512490 A | 04-02-2022 |
| | | JP 2022512491 A | 04-02-2022 |
| | | JP 2022515347 A | 18-02-2022 |
| | | JP 2022515348 A | 18-02-2022 |
| | | KR 20210094115 A | 28-07-2021 |
| | | KR 20210094116 A | 28-07-2021 |
| | | KR 20210094117 A | 28-07-2021 |
| | | KR 20210094118 A | 28-07-2021 |
| | | TW 202036062 A | 01-10-2020 |
| | | TW 202036063 A | 01-10-2020 |
| | | TW 202038296 A | 16-10-2020 |
| | | TW 202105435 A | 01-02-2021 |
| | | TW 202217896 A | 01-05-2022 |
| | | US 2020192027 A1 | 18-06-2020 |
| | | US 2020192028 A1 | 18-06-2020 |
| | | US 2020194217 A1 | 18-06-2020 |
| | | US 2020194218 A1 | 18-06-2020 |
| | | US 2021066036 A1 | 04-03-2021 |
| | | WO 2020131831 A1 | 25-06-2020 |
| | | WO 2020131839 A1 | 25-06-2020 |
| | | WO 2020131843 A1 | 25-06-2020 |
| | | WO 2020131848 A1 | 25-06-2020 |
| JP 2003133252 A | 09-05-2003 | NONE | |
| US 2020185201 A1 | 11-06-2020 | CN 113169021 A | 23-07-2021 |
| | | JP 7227373 B2 | 21-02-2023 |
| | | JP 7566948 B2 | 15-10-2024 |
| | | JP 2022510432 A | 26-01-2022 |
| | | JP 2023081884 A | 13-06-2023 |
| | | KR 20210091326 A | 21-07-2021 |
| | | KR 20230159648 A | 21-11-2023 |
| | | TW 202034374 A | 16-09-2020 |
| | | TW 202405876 A | 01-02-2024 |

EPO FORM P0459

For more details about this annex : see Official Journal of the European Patent Office, No. 12/82

page 1 of 2

## ANNEX TO THE EUROPEAN SEARCH REPORT
## ON EUROPEAN PATENT APPLICATION NO.

EP 24 21 4067

This annex lists the patent family members relating to the patent documents cited in the above-mentioned European search report.
The members are as contained in the European Patent Office EDP file on
The European Patent Office is in no way liable for these particulars which are merely given for the purpose of information.

04-08-2025

| Patent document cited in search report | Publication date | Patent family member(s) | Publication date |
|---|---|---|---|
| | | US 2020185201 A1 | 11-06-2020 |
| | | US 2022051880 A1 | 17-02-2022 |
| | | WO 2020117939 A1 | 11-06-2020 |
| US 2016071693 A1 | 10-03-2016 | CN 107078010 A | 18-08-2017 |
| | | JP 6769952 B2 | 14-10-2020 |
| | | JP 2017533542 A | 09-11-2017 |
| | | KR 20170052638 A | 12-05-2017 |
| | | TW 201611083 A | 16-03-2016 |
| | | US 2016071693 A1 | 10-03-2016 |
| | | WO 2016040006 A1 | 17-03-2016 |
| WO 2023197125 A1 | 19-10-2023 | CN 119013754 A | 22-11-2024 |
| | | WO 2023197125 A1 | 19-10-2023 |
| US 2019237292 A1 | 01-08-2019 | KR 20180065072 A | 18-06-2018 |
| | | US 2018158643 A1 | 07-06-2018 |
| | | US 2019237292 A1 | 01-08-2019 |
| US 4334169 A | 08-06-1982 | DE 2941983 A1 | 24-04-1980 |
| | | GB 2034516 A | 04-06-1980 |
| | | JP H0142109 B2 | 11-09-1989 |
| | | JP S5553853 A | 19-04-1980 |
| | | US 4334169 A | 08-06-1982 |
| US 4701678 A | 20-10-1987 | NONE | |
| JP S53153856 U | 04-12-1978 | JP S57519 Y2 | 06-01-1982 |
| | | JP S53153856 U | 04-12-1978 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2022101072 A1
- WO 2012165955 A
- WO 2021156121 A1
- WO 2021204734 A1
- EP 23211553
- WO 2021156121 A
- WO 2021204734 A
- EP 3869535 A1
- WO 2021165136 A1
- WO 2022058252 A1
- WO 2022008286 A1
- WO 2021165135 A1